# EUROPEAN PATENT APPLICATION

(11) **EP 4 171 180 A1**
(43) Date of publication of application: **26.04.2023**
(21) Application number: 21832357.4
(22) Date of filing: 24.06.2021
(51) Int. Cl.: H05K 1/18, G02B 6/42

(54) **OPTICAL CAGE ASSEMBLY AND OPTICAL COMMUNICATION EQUIPMENT**

(30) Priority: 28.06.2020 CN 202010601065
(71) Applicant: Huawei Technologies Co., Ltd., Longgang District, Shenzhen, Guangdong 518129 (CN)
(72) Inventor: WANG, Dingding, Shenzhen, Guangdong 518129 (CN); WANG, Jianyang, Shenzhen, Guangdong 518129 (CN); LI, Chaoxing, Shenzhen, Guangdong 518129 (CN); YUAN, Changfa, Shenzhen, Guangdong 518129 (CN)
(74) Representative: Maiwald GmbH
(86) International application number: PCT/CN2021/102212
(87) International publication number: WO 2022/001839

(57) **Abstract**

This application provides an optical cage component and an optical communications device. The optical cage component includes an optical cage and a base. The optical cage has a mounting surface. The base is configured to connect to the mounting surface. When the optical cage is assembled on a circuit board, a component and the base may be first fixed on a surface of the circuit board using an SMT technology. After optical inspection is performed on the component and the base, the optical cage is fixed on the base. Based on the foregoing process, it is ensured that the optical inspection can be performed on the component between the optical cage and the circuit board, to help ensure mounting quality of the component. In addition, a front projection area of the base on a reference plane is less than an area of the mounting surface, where the reference plane is a plane on which the mounting surface is located. This avoids a case in which an area occupied by the base on the circuit board is less than an area of a component mounted on the circuit board blocked by the optical cage, to effectively ensure utilization of an area of the surface of the circuit board.

## Description

### CROSS-REFERENCE TO RELATED APPLICATIONS

This application claims priority to Chinese Patent Application No. 202010601065.7, filed with the China National Intellectual Property Administration on June 28, 2020 and entitled "OPTICAL CAGE COMPONENT AND OPTICAL COMMUNICATIONS DEVICE", which is incorporated herein by reference in its entirety.

### TECHNICAL FIELD

This application relates to the field of optical communications technologies, and in particular, to an optical cage component and an optical communications device.

### BACKGROUND

As an important module for implementing conversion between an electrical signal and an optical signal, an optical module is widely applied in optical communications devices such as a router and a switch. An optical cage is fixed on a circuit board of the optical communications device. The optical module can fit in a slot of the optical cage in a pluggable manner.

To increase area utilization of the circuit board, generally, some components such as a power-related component supplying power to the optical module are further disposed between the circuit board and the optical cage.

When a surface mount technology (surface mount technology, SMT) is used to assemble the optical cage, the component and the optical cage need to be welded to the circuit board at the same time. A component under the optical cage is blocked by the optical cage. In this case, optical inspection cannot be performed.

### SUMMARY

This application provides an optical cage component and an optical communications device, to facilitate inspection of a component between an optical cage and a circuit board when the optical cage is assembled.

According to a first aspect, an optical cage component is provided. The optical cage component includes an optical cage and a base. The optical cage has a mounting surface. The base is configured to connect to the mounting surface. When the optical cage is assembled on a circuit board, a component and the base may be first fixed on a surface of the circuit board using an SMT technology. After optical inspection is performed on the component and the base, the optical cage is fixed on the base. Based on the foregoing process, it is ensured that the optical inspection can be performed on the component between the optical cage and the circuit board, to help ensure mounting quality of the component. In addition, a front projection area of the base on a reference plane is less than an area of the mounting surface, where the reference plane is a plane on which the mounting surface is located. This avoids a case in which an area occupied by the base on the circuit board is less than an area of a component mounted on the circuit board blocked by the optical cage, to effectively ensure utilization of an area of the surface of the circuit board.

The base may have a plurality of forms. In a specific implementation, the base may be a frame structure.

In a specific implementable manner, the mounting surface includes a first side edge and a second side edge that are disposed opposite to each other, and a third side edge and a fourth side edge that are disposed opposite to each other. The third side edge connects one end of the first side edge to one end of the second side edge. The fourth side edge connects the other end of the first side edge to the other end of the second side edge. The base includes a first support bracket configured to extend along the first side edge and a second support bracket configured to extend along the second side edge, to provide basically stable support for the optical cage and less occupy the area of the surface of the circuit board.

In a specific implementation, the base may further include a third support bracket. The third support bracket connects the first support bracket to the second support bracket, to improve stability of the base.

In a specific implementation, the third support bracket may extend along the third side edge, or the third support bracket connects a middle part of the first support bracket to a middle part of the second support bracket.

In a specific implementation, the base may further include a fourth support bracket. The fourth support bracket connects the first support bracket to the second support bracket, to further improve stability of the base.

In a specific implementation, the fourth support bracket may connect a middle part of the first support bracket and a middle part of the second support bracket, to improve stability of the base and reduce a suspension distance of the optical cage. Alternatively, the fourth support bracket extends along the fourth side edge, so that a stable quadrilateral structure is formed for the base.

In a specific implementation, the base may further include a fifth support bracket. The fifth support bracket connects a middle part of a third support bracket to a middle part of the fourth support bracket, to further improve stability of the base.

In a specific implementation, in addition to the frame structure, the base may further be a base including a plurality of support posts that are distributed at intervals.

In a specific implementation, the plurality of support posts are evenly distributed on the mounting surface, to provide even support for the optical cage.

In a specific implementation, a plurality of crimp pins may be further disposed on the mounting surface. Each crimp pin fits in the base through plug-connection.

There may be a plurality of manners in which the crimp pin is plug-connected to the base. In a specific implementation, the base has a plurality of crimp holes in a one-to-one correspondence with the plurality of crimp pins. An accommodation cavity corresponding to each crimp hole is formed in the base. Each crimp pin includes a first connection section and a stopper part. One end of each first connection section is connected to the mounting surface, and the other end is connected to a corresponding stopper part. The stopper part of each crimp pin is configured to plug-connect to the corresponding accommodation cavity through the corresponding crimp hole, and is configured to prevent the corresponding crimp pin from slipping out of the corresponding crimp hole.

In a specific implementation, each stopper part has a guide structure, to help the stopper part enter the crimp hole.

There may be a plurality of cases for a location of the crimp hole. In a specific implementation, the base has a first surface away from the circuit board, a second surface facing the circuit board, and a connection surface connecting the first surface to the second surface. Each crimp hole extends from the accommodation cavity to the first surface. Each first connection section extends in a direction perpendicular to the mounting surface.

In another specific implementation, the base has a first surface away from the circuit board, a second surface facing the circuit board, and a connection surface connecting the first surface to the second surface. Each crimp hole extends from the accommodation cavity to the connection surface. A second connection section is further disposed between each first connection section and the corresponding stopper part. An included angle between an extension direction of the second connection section and the mounting surface is an acute angle.

In a specific implementation, each crimp pin has one or more hanging holes. An opening direction of the hanging hole is parallel to the mounting surface. A plurality of protrusion parts in a one-to-one correspondence with the one or more hanging holes are disposed on a connection surface of the base. Each protrusion part is configured to plug-connect to a corresponding hanging hole.

In a specific implementation, a surface that is of each protrusion part and that is away from the circuit board forms a guide surface to guide the crimp pin.

According to a second aspect, an optical communications device is provided. The optical communications device includes:
a circuit board and the optical cage component provided in any one of the foregoing technical solutions. A base is fixed on a surface of the circuit board. A mounting surface of an optical cage is connected to the base. When the optical cage is assembled on the circuit board, a component and the base may be first fixed on the surface of the circuit board using an SMT technology. After optical inspection is performed on the component and the base, the optical cage is fixed on the base. Based on the foregoing process, it is ensured that the optical inspection can be performed on the component between the optical cage and the circuit board, to help ensure mounting quality of the component and improve stability of the optical communications device.

### BRIEF DESCRIPTION OF DRAWINGS

FIG. 1 is a schematic diagram of a scenario to which an optical cage component can be applied according to an embodiment of this application;
FIG. 2 is a bottom view of an optical cage 20 in FIG. 1;
FIG. 3 is a schematic diagram when a base 10 in FIG. 1 is mounted on a circuit board 30;
FIG. 4 is a top view of an optical cage component 01 in FIG. 1;
FIG. 5 is a schematic partial view of a cutaway drawing in an A-A direction in FIG. 1;
FIG. 6 is a schematic diagram before an optical cage 20 is assembled on a second support bracket 12 in FIG. 5;
FIG. 7 is a schematic diagram of a partial structure in another manner in which an optical cage in an optical cage component fits in a base according to an embodiment of this application;
FIG. 8 is a schematic diagram before an optical cage 20 is assembled on a second support bracket 12 in FIG. 7;
FIG. 9 is a top view when a fixing manner shown in FIG. 7 is used between an optical cage and a base;
FIG. 10 is a schematic diagram of a partial structure in another manner in which an optical cage in an optical cage component fits in a base according to an embodiment of this application;
FIG. 11 is a side view of an optical cage component shown in FIG. 10;
FIG. 12 is a schematic diagram before an optical cage 20 is assembled on a base 10 shown in FIG. 10;
FIG. 13 is a top view when a fixing manner shown in FIG. 10 is used between an optical cage and a base;
FIG. 14 is a top view of another optical cage component according to an embodiment of this application;
FIG. 15 is a top view of another optical cage component according to an embodiment of this application;
FIG. 16 is a top view of another optical cage component according to an embodiment of this application;
FIG. 17 is a top view of another optical cage component according to an embodiment of this application; and
FIG. 18 is a top view of another optical cage component according to an embodiment of this application.

### DESCRIPTION OF EMBODIMENTS

To make objectives, technical solutions, and advantages of this application clearer, the following further describes this application in detail with reference to the accompanying drawings.

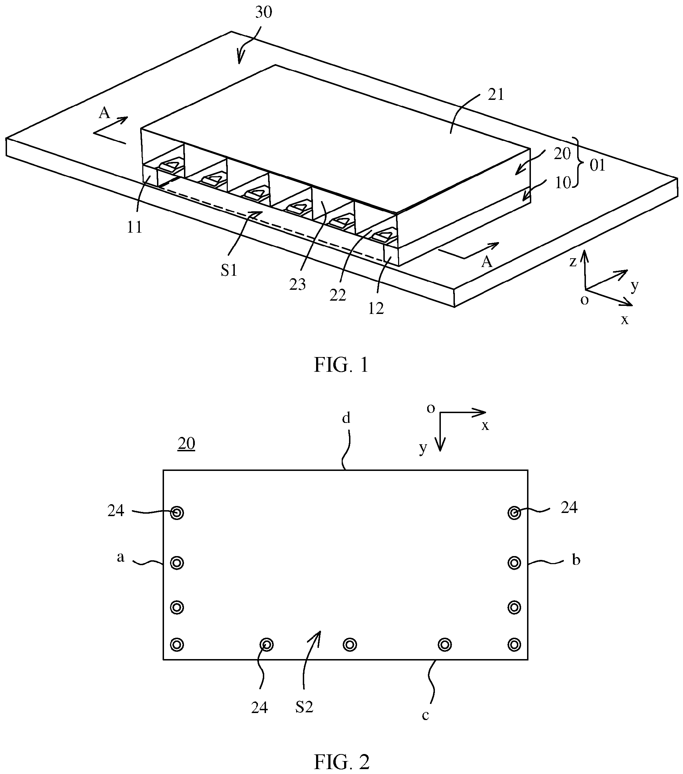

To facilitate understanding of an optical cage component provided in embodiments of this application, first, an application scenario of the optical cage component is described. The optical cage component may be applied to optical communications devices such as a router and a switch in a data communications system. For example, FIG. 1 is a schematic diagram of a scenario to which an optical cage component can be applied according to an embodiment of this application. Specifically, only a circuit board 30 and an optical cage component 01 in an optical communications device are represented. In a specific product, the foregoing circuit board 30 and the foregoing optical cage component 01 may be encapsulated by using a housing (not shown in the figure). The optical cage component 01 includes a base 10 and an optical cage 20. The optical cage 20 is fixed on the circuit board 30 by using the base 10.

FIG. 2 is a bottom view of the optical cage 20 in FIG. 1 (an elevational view in the z-axis). For example, with reference to FIG. 1 and FIG. 2, the optical cage 20 includes a top wall 21 and a bottom wall 22 (a wall disposed close to the circuit board 30) that are disposed opposite to each other. A plurality of sidewalls 23 that are distributed at intervals are disposed between the top wall 21 and the bottom wall 22, to divide space between the top wall 21 and the bottom wall 22 into a plurality of slots disposed in parallel and used for plug-connection of optical modules. A surface that is of the bottom wall 22 and that is away from the top wall 21 is referred to as a mounting surface (that is, a surface used for mounting on the base 10, denoted as S2). The top wall 21, the bottom wall 22, and the sidewalls 23 of the optical cage 20 may be prepared by using a material with good heat dissipation and certain elasticity, for example, steel or copper. The mounting surface S2 has a first side edge a, a second side edge b, a third side edge c, and a fourth side edge d. The first side edge a and the second side edge b are disposed opposite to and parallel to each other. The third side edge c and the fourth side edge d are disposed opposite to and parallel to each other. The third side edge c connects one end of the first side edge a in a positive direction of the y-axis to one end of the second side edge b in the positive direction of the y-axis. The fourth side edge d connects one end of the first side edge a in a negative direction of the y-axis to one end of the second side edge b in the negative direction of the y-axis. A plurality of crimp pins 24 that are distributed at intervals are separately disposed on inner sides of the first side edge a, the second side edge b, and the third side edge c.

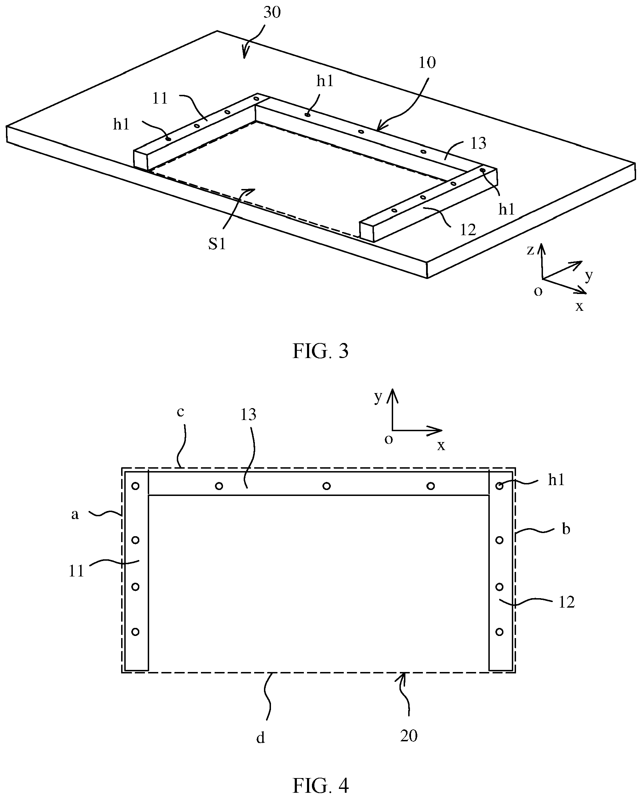

FIG. 3 is a schematic diagram when the base 10 in FIG. 1 is mounted on the circuit board 30. For example, with reference to FIG. 3, the base 10 includes a first support bracket 11, a second support bracket 12, and a third support bracket 13. The three support brackets are all strip-shaped structures, and have square cross sections (this is merely an example, and the cross section is not limited to a square and may alternatively be a regular hexagon or the like, provided that the support bracket can provide a support function). The first support bracket 11 and the second support bracket 12 are disposed opposite to and parallel to each other, for example, both extend along the direction of the y-axis. The third support bracket 13 connects one end of the first support bracket 11 in the positive direction of the y-axis to one end of the second support bracket 12 in the positive direction of the y-axis. A structure of each part of the base 10 may use a material with certain support strength, for example, steel and copper.

FIG. 4 is a top view of the optical cage component 01 in FIG. 1. To clearly express a relative location relationship between the optical cage 20 and the base 10, dashed lines are used to represent an outline of the optical cage 20. With reference to FIG. 4, the first support bracket 11 extends along the first side edge a of the mounting surface S2, the second support bracket 12 extends along the second side edge b, and the third sidewall 13 extends along the third side edge c.

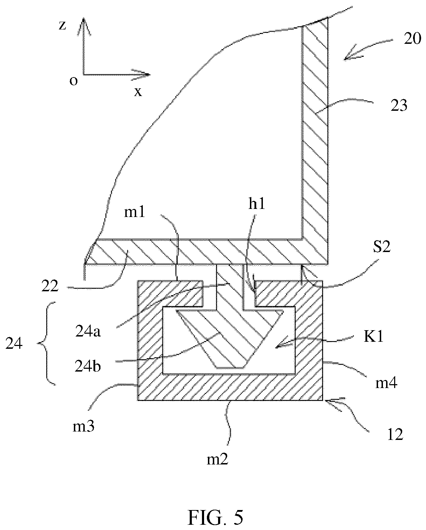

FIG. 5 is a schematic partial view of a cutaway drawing in an A-A direction in FIG. 1. Specifically, FIG. 5 is a schematic diagram of fitting between the optical cage 20 and the second support bracket 12. With reference to FIG. 5, the second support bracket 12 has a first surface m1 (a surface away from the circuit board 30) and a second surface m2 (a surface facing the circuit board 30) that are disposed opposite to each other, and a connection surface m3 and a connection surface m4 that connect the first surface m1 to the second surface m2. The second support bracket 12 is hollow inside to form an accommodation cavity K1. The accommodation cavity K1 is connected to the first surface m1 by using a plurality of crimp holes h1. An outer diameter of the crimp hole h1 is less than a size of the accommodation cavity K1 along the x-axis. The crimp pin 24 includes a first connection section 24a and a stopper part 24b. One end of the first connection section 24a is fixedly connected to the mounting surface S2, and the other end is connected to the stopper part 24b. An outer diameter of the stopper part 24b is greater than an outer diameter of the first connection section 24a. A cross sectional area of the stopper part 24b gradually increases in a direction from the second surface m2 to the first surface m1 (that is, a positive direction of the z-axis), to form a circular truncated cone structure. The outer diameter of the crimp hole h1 is between a maximum outer diameter and a minimum outer diameter of the stopper part 24b. A material of the crimp pin 24 may be a material with certain elasticity, for example, steel or copper.

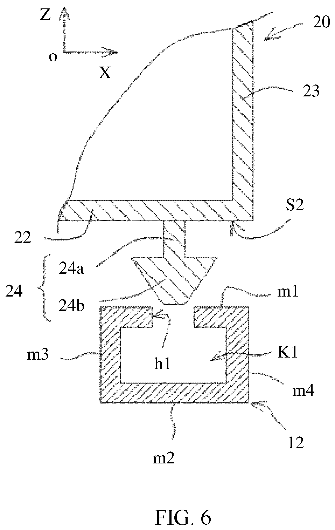

FIG. 6 is a schematic diagram before the optical cage 20 is assembled on the second support bracket 12 in FIG. 5. For example, with reference to FIG. 5, when the crimp pin 24 is assembled on the second support bracket 12, the crimp pin 24 is aligned with the corresponding crimp hole h1, and the optical cage 20 is moved in a negative direction of the z-axis. Because the outer diameter at an end that is of the stopper part 24b and that is close to the second support bracket 12 is relatively small, the stopper part 24b may be first plugged in the crimp hole h1, and the optical cage 20 may be further pressed downward. Because of the elasticity of the materials of the stopper part 24b and the second support bracket 12, the stopper part 24b extends the crimp hole h1 and enters the accommodation cavity K1. Detachable connection is implemented between the base 10 and the optical cage 20. An inclined surface of the circular truncated cone structure of the stopper part 24b forms a guide structure. The so-called "guide structure" is a structure that can be in contact with and slide on an inner wall of the crimp hole h1 and that can guide the stopper part 24b into the crimp hole h1. However, because a size of an end that is of the stopper part 24b and that is close to the first connection section 24a is greater than the crimp hole h1, the stopper part 24b is firmly fixed in the accommodation cavity K1. It is not easy to detach the optical cage 20 from the base 10.

With reference to FIG. 1 to FIG. 3, similarly to the second support bracket 12, the first support bracket 11 and the third support bracket 13 have the same structure as the second support bracket 12, and include parts using names that are the same as those used in the second support bracket 12 (for example, the first surface, the second surface, the connection surface, an accommodation slot, and the crimp hole) and that express the same meanings. Therefore, the first surface, the second surface, and the connection surface are also respectively referred to as a first surface, a second surface, and a connection surface of the base 10. In other words, the base 10 has the first surface and the second surface that are disposed opposite to each other, and the connection surface that connects the first surface to the second surface. The plurality of crimp pins 24 on the mounting surface S2 of the optical cage 20 respectively fit in the crimp holes on the first surface (the first surfaces of the first support bracket 11, the second support bracket 13, and the third support bracket 13) of the base 10 in a one-to-one correspondence. For a fitting manner, refer to a fitting manner between the crimp pins 24 and the second support bracket 12 in FIG. 5 and FIG. 6.

The following describes an example of a process of welding a component and the optical cage component 01 to the surface of the circuit board 30 by using an SMT technology with reference to FIG. 1 to FIG. 3. First, a solder paste is printed on a surface that is of the circuit board 30 and on which the base 10 is to be mounted. Then, with reference to FIG. 3, glue is dispensed to mount the base 10 and the to-be-welded component at predetermined locations on the surface of the circuit board 30 by using the printed solder paste and then is cured. In FIG. 3, the base 10 forms a blocking region S1 on the surface of the circuit board 30, and the to-be-welded component may be specifically mounted in a range of the blocking region S1 and in a region outside the base 10. Then, the to-be-welded component and the base 10 are welded to the surface of the circuit board 30 by using a welding process such as reflow soldering. Afterwards, inspection is performed on the base 10 and a component on the surface of the circuit board 30 by using an automated optical inspection (automated optical inspection, AOI) technology. Because the component in the range of the blocking region S1 has not been blocked by the optical cage 20 yet, optical inspection can be performed on the component in the region. Next, the crimp pin 24 of the optical cage 20 fits in the crimp hole h1 of the base 10 in a detachable manner. For the fitting manner, refer to the foregoing descriptions of FIG. 5 and FIG. 6. In this case, projection of the optical cage 20 on the circuit board 30 covers the blocking region S 1. In addition, automatic optical inspection is completed on the component in the blocking region S 1. In this case, inspection on the component is not affected when the optical cage 20 blocks the blocking region S1. A plane on which the mounting surface S2 is located is used as a reference plane. A front projection area of the base 10 on the reference plane is less than an area of the mounting surface S2. The mounting surface S2 is basically parallel to or fully parallel to the surface of the circuit board 30. In this way, the following case can be avoided: Because the base 10 is mounted on the circuit board 30 in advance, an area occupied by the base 10 is greater than an area on the circuit board 30 in which inspection cannot be performed on the component due to blocking of the optical cage 20, to ensure that area utilization of disposing the component on the surface of the circuit board 30 is effectively improved after the base 10 is disposed.

In addition to the manner provided in the embodiments corresponding to FIG. 5 and FIG. 6 in which the crimp pin 24 fits in the base 10, another manner may be used, provided that the crimp pin fits in the base through plug-connection. The following is described by using examples.

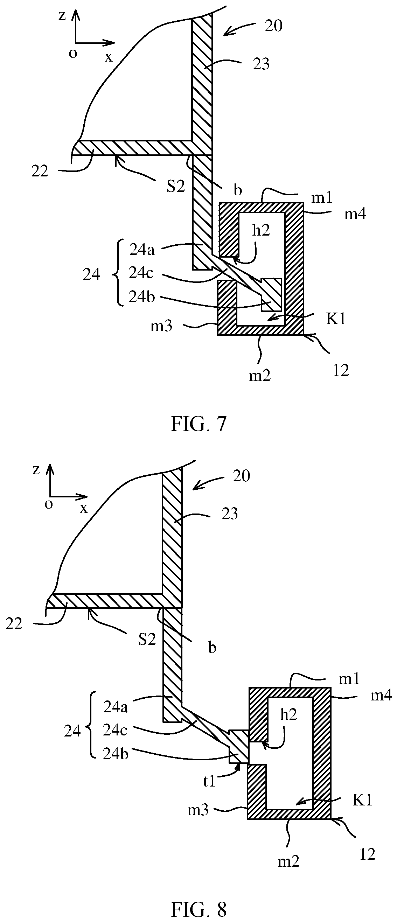

FIG. 7 is a schematic diagram of a partial structure in another manner in which an optical cage in an optical cage component fits in a base according to an embodiment of this application. With reference to FIG. 7, a difference between this embodiment and the embodiments corresponding to FIG. 5 and FIG. 6 is that the crimp pin 24 includes a first connection section 24a, a second connection section 24c, and a stopper part 24b. One end of the first connection section 24a is connected to the mounting surface S2, and the other end is connected to the second connection section 24c. One end that is of the second connection section 24c and that is away from the first connection section 24a is connected to the stopper part 24b. For example, the first connection section 24a extends in a direction perpendicular to the mounting surface S2, and the second connection section 24b extends in an inclined direction of the mounting surface S2. Specifically, an acute angle may exist between an extension direction of the second connection section 24b and the mounting surface S2, for example, the acute angle may be between 45° and 75°.

FIG. 8 is a schematic diagram before the optical cage 20 is assembled on the second support bracket 12 in FIG. 7. The following describes a process in which the crimp pin 24 fits in the second support bracket 12 with reference to FIG. 8. The stopper part 24b is put close to the connection surface m3. The optical cage 20 is pressed downward. Because an acute angle exists between the second connection section 24c and the mounting surface S2 in a natural unpressed state, the second connection section 24c is elastically deformed due to press of the connection surface m3. In this case, a size of the stopper part 24b in the direction of the x-axis is less than a size of the stopper part 24b in the direction of the z-axis. When a bottom surface t1 of the stopper part 24b slides to the crimp hole h2 of the connection surface m3, one end of the bottom surface t1 of the stopper part 24b moves in the crimp hole h2 due to press of the second connection section 24c. The optical cage 20 is further pressed, so that the bottom surface t1 of the stopper part 24b is in contact with a sidewall of the crimp hole h2. The stopper part 24b rotates around the y-axis, so that the bottom surface t1 of the stopper part 24b faces the connection surface m4. After rotation, the stopper part 24b may slide into the crimp hole h2. Still with reference to FIG. 7, the stopper part 24b slides into the accommodation cavity K1, and the stopper part 24b reverts to a state in which the bottom surface t1 faces the second surface m2. An acute angle still exists between an extension direction of the second connection section 24c and the mounting surface S2. In this case, a size of the stopper part 24b in the direction of the z-axis is greater than an inner diameter of the crimp hole h2, and the stopper part 24b may be clamped on an inner surface of a sidewall corresponding to the connection surface m3 of the second support bracket 12, to prevent the crimp pin 24 from fully slipping out of the crimp hole h2.

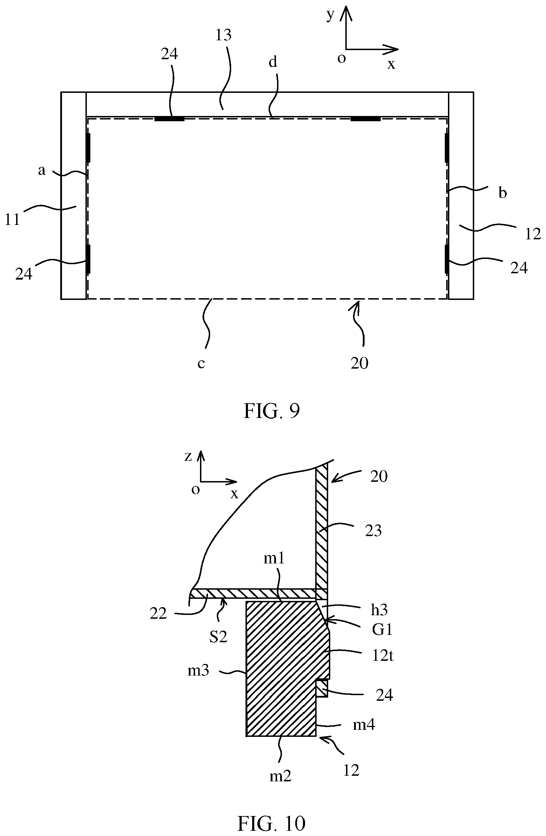

FIG. 9 is a top view when a fixing manner shown in FIG. 7 is used between an optical cage and a base. A dashed line box is merely used to show an outline of the optical cage 20, to indicate a location of the optical cage 20. With reference to FIG. 9, the crimp pins 24 are disposed on all of the first side edge a, the second side edge b, and the fourth side edge d of the mounting surface S2 of the optical cage 20. Each crimp pin 24 on the first side edge a is disposed opposite to one crimp pin 24 on the second side edge b. The crimp holes on the first support bracket 11 are disposed opposite to the crimp holes on the second support bracket 12. Therefore, when the optical cage 20 is moved downward, the crimp pins 24 disposed opposite to each other on two sides bear balanced force.

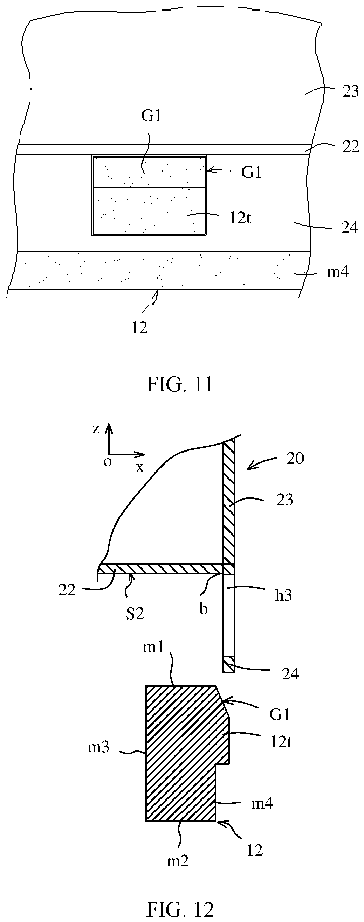

FIG. 10 is a schematic diagram of a partial structure in another manner in which an optical cage in an optical cage component fits in a base according to an embodiment of this application. FIG. 11 is a side view of the optical cage component shown in FIG. 10 (a view in the negative direction of the x-axis). With reference to FIG. 10 and FIG. 11, a difference between the optical cage component shown in FIG. 10 and the optical cage component shown in FIG. 5 is that in FIG. 10, the crimp pin 24 may be a plate-shaped structure that extends along the second side edge b of the mounting surface S2 and that is perpendicular to the mounting surface S2. A hanging hole h3 through the crimp pin 24 is disposed along a thickness direction of the crimp pin 24. An opening direction of the hanging hole h3 is parallel to the mounting surface S2. A protrusion part 12t protruding from the connection surface m4 is disposed on the connection surface m4 of the second support bracket of the base 10. The protrusion part 12t is configured to form an inclined guide surface G1 away from the surface of the circuit board.

FIG. 12 is a schematic diagram before the optical cage 20 in the optical cage component is assembled on the base 10 shown in FIG. 10. With reference to FIG. 10 to FIG. 12, a process in which the optical cage 20 is assembled to the base 10 is described. First, the crimp pin 24 is approximately aligned with the protrusion part 12t. The optical cage 20 is moved downward (in the negative direction of the z-axis). A bottom end of the crimp pin 24 is in contact with the guide surface G1 of the protrusion part 12t. The optical cage is further moved downward. The crimp pin 24 is extended in the positive direction of the x-axis by the guide surface G1. When the hanging hole h3 is aligned with the protrusion part 12t, the protrusion part 12t extends into the hanging hole h3, and the protrusion part 12t is clamped by the inner wall of the hanging hole h3, so that the protrusion part 12t and the crimp pin 24 are relatively fixed, to implement detachable connection. The presence of the guide surface G1 enables the crimp pin 24 to move downward smoothly even if a side surface of the crimp pin 24 in the x-axis direction is not aligned with a surface that is of the protrusion part 12t and that is away from the connection surface m3, and finally enables fitting between the protrusion part 12t and the hanging hole h3.

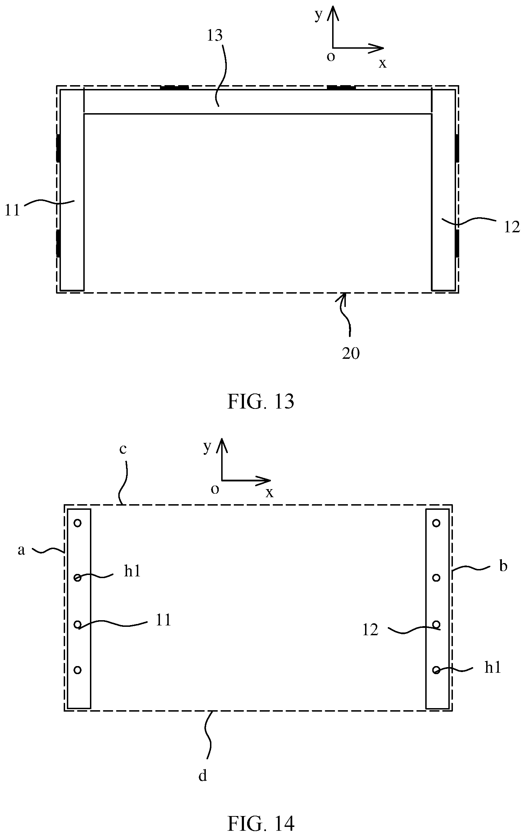

FIG. 13 is a top view when a fixing manner shown in FIG. 10 is used between an optical cage and a base. A dashed line box is merely used to show an outline of the optical cage 20, to indicate a location of the optical cage 20. With reference to FIG. 13, the crimp pins 24 are disposed on all of the first side edge a, the second side edge b, and the fourth side edge d of the mounting surface S2 of the optical cage 20. Each crimp pin 24 on the first side edge a is disposed opposite to one crimp pin 24 on the second side edge b. The crimp pin 24 on the first side edge a is located at a surface that is of the first support bracket 11 and that is away from the second support bracket 12. The crimp pin 24 on the second side edge b is located at a surface that is of the second support bracket 12 and that is away from the first support bracket 11. The crimp holes on the first support bracket 11 are disposed away from (only as an example, or may be disposed opposite to) the crimp holes on the second support bracket 12. Therefore, when the optical cage 20 is moved downward, the crimp pins 24 disposed opposite to each other on two sides bear balanced force.

A form of the base 10 used in the embodiments corresponding to FIG. 4, FIG. 9, and FIG. 13 is merely an example. The base 10 is merely a frame structure. The so-called "frame structure" indicates a structure formed through splicing strip-shaped structures on the same plane. The frame structure is used as the base. When providing stable support for the optical cage 20, an area occupied by the base 10 on the circuit board 30 (FIG. 1) may be reduced as much as possible. The following describes another possible frame structure form of the base 10 by using an example of the accompanying drawing.

FIG. 14 is a top view of another optical cage component according to an embodiment of this application. A dashed line box is merely used to show an outline of the optical cage 20 (this is the same below, and details are not described again). A difference between FIG. 14 and FIG. 4 is that the third support bracket 13 is canceled. Basic stable support can also be provided for the optical cage 20. A greater area can be vacated on the circuit board 30 to mount the component.

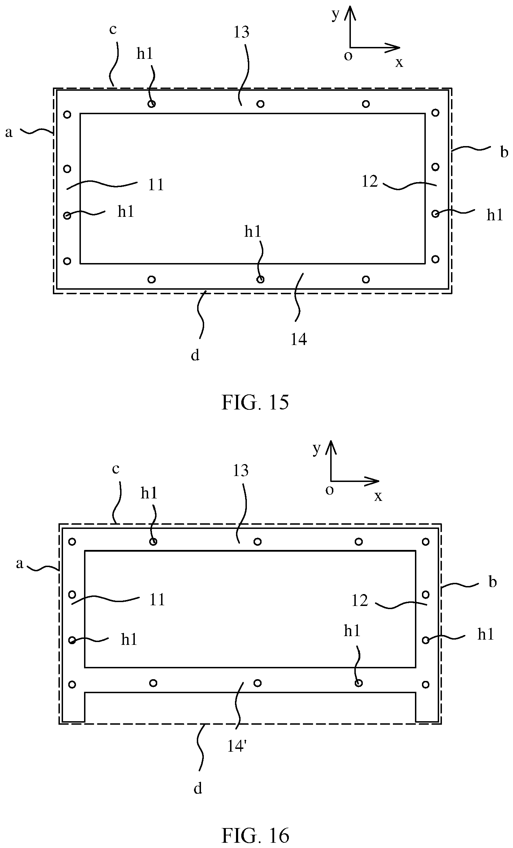

FIG. 15 is a top view of another optical cage component according to an embodiment of this application. A difference between FIG. 15 and FIG. 4 is that the base 10 further includes a fourth support bracket 14. The fourth support bracket 14 connects one end that is of the second support bracket 12 and that is away from the third support bracket 13 to one end that is of the first support bracket 11 and that is away from the third support bracket 13. In other words, the fourth support bracket 14 extends along the fourth side edge d, so that the base 10 forms a fixed quadrilateral structure.

FIG. 16 is a top view of another optical cage component according to an embodiment of this application. A difference between FIG. 16 and FIG. 15 is that the fourth support bracket 14 connects a middle part of the second support bracket 12 to a middle part of the first support bracket 11. In comparison with the form in FIG. 15, a suspension distance of the mounting surface S2 of the optical cage 20 in the direction of the y-axis is shortened. The middle parts are effectively supported. No additional structure is added on the basis of FIG. 15. In addition, the fourth support bracket 14 may further connect the second support bracket 12 to the first support bracket 11 at other locations, provided that the second support bracket 12 is connected to the first support bracket 11.

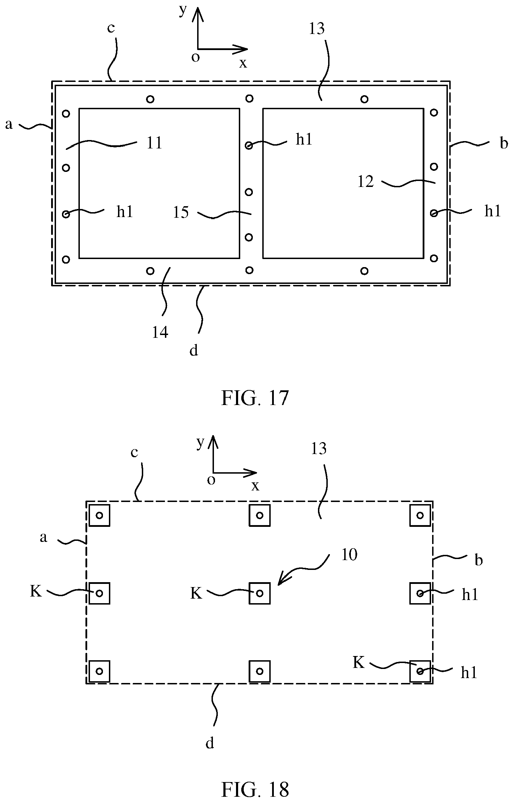

FIG. 17 is a top view of another optical cage component according to an embodiment of this application. A difference between FIG. 17 and FIG. 15 is that the base 10 further includes a fifth support bracket 15. The fifth support bracket 15 connects a middle part of the third support bracket 13 and a middle part of the fourth support bracket 14, to further increase stability of the base 10.

In addition, based on FIG. 4, the third support bracket 13 may be moved, so that one end of the third support bracket 13 is connected to the middle part of the first support bracket 11, and the other end is connected to the middle part of the second support bracket 12, to form an "H" structure. Alternatively, one end of the third support bracket 13 is connected to one end of the first support bracket 11 in the positive direction of the y-axis and one end of the second support bracket 12 in the negative direction of the y-axis.

In addition to the frame structure, the base may further use the following forms:
FIG. 18 is a top view of another optical cage component according to an embodiment of this application. In FIG. 18, the base 10 includes a plurality of support posts K. These support posts K are evenly distributed under the mounting surface S2 to provide relatively even support for the optical cage 20. However, this is merely an example. A distribution manner of the support posts K may also be distribution based on structural strength at each part of the optical cage 20.

The forms of the base 10 in FIG. 14 to FIG. 18 are not limited to the fixing manner between the optical cage 20 and the base 10 in FIG. 5, and may alternatively be connected in the form in FIG. 7, the form in FIG. 10, or another form.

Based on the same technical concept, an embodiment of this application further provides an optical communications device. The optical communications device includes:
a circuit board and the optical cage component provided in any one of the foregoing embodiments. A base is fixed on a surface of the circuit board. A mounting surface of an optical cage is detachably connected to the base.

FIG. 1 to FIG. 6 are used as an example. The base 10 and a component are first mounted on the surface of the circuit board 30 in an SMT manner, and AOI optical inspection is performed on a component in the blocking region S1. Then the optical cage 20 is fixed on the base 10. In the foregoing process, when the component is mounted using the SMT technology, before the optical cage 20 is mounted, AOI optical inspection is first performed on a component that may be blocked by the optical cage 20, to ensure mounting stability of the component and improve performance of the optical communications device.

In addition, all the components in the accompanying drawings in embodiments of this application are merely used to indicate a working principle of the optical cage component and the optical communications device, and do not truly reflect an actual size relationship among the components.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An optical cage component, comprising:
an optical cage, wherein the optical cage has a mounting surface; and
a base, wherein the base is configured to connect to the mounting surface; and
a front projection area of the base on a reference plane is less than an area of the mounting surface, wherein the reference plane is a plane on which the mounting surface is located.

2. The optical cage component according to claim 1, wherein the base is a frame structure.

3. The optical cage component according to claim 2, wherein the mounting surface comprises a first side edge and a second side edge that are disposed opposite to each other and a third side edge and a fourth side edge that are disposed opposite to each other, the third side edge connects one end of the first side edge to one end of the second side edge, and the fourth side edge connects the other end of the first side edge to the other end of the second side edge; and
the base comprises a first support bracket configured to extend along the first side edge and a second support bracket configured to extend along the second side edge.

4. The optical cage component according to claim 3, wherein the base further comprises a third support bracket, and the third support bracket connects the first support bracket to the second support bracket.

5. The optical cage component according to claim 4, wherein the third support bracket extends along the third side edge; or
the third support bracket connects a middle part of the first support bracket to a middle part of the second support bracket.

6. The optical cage component according to claim 3, wherein the base further comprises a fourth support bracket, and the fourth support bracket connects the first support bracket to the second support bracket.

7. The optical cage component according to claim 6, wherein the fourth support bracket connects a middle part of the first support bracket to a middle part of the second support bracket; or
the fourth support bracket extends along the fourth side edge.

8. The optical cage component according to claim 6, wherein the base further comprises a fifth support bracket, and the fifth support bracket connects a middle part of a third support bracket to a middle part of the fourth support bracket.

9. The optical cage component according to claim 1, wherein the base comprises a plurality of support posts that are distributed at intervals.

10. The optical cage component according to claim 9, wherein the plurality of support posts are evenly distributed on the mounting surface.

11. The optical cage component according to any one of claims 1 to 10, wherein a plurality of crimp pins are disposed on the mounting surface, and each crimp pin fits in the base through plug-connection.

12. The optical cage component according to claim 11, wherein the base has a plurality of crimp holes in a one-to-one correspondence with the plurality of crimp pins, and an accommodation cavity corresponding to each crimp hole is formed in the base;
each crimp pin comprises a first connection section and a stopper part, one end of each first connection section is connected to the mounting surface, and the other end is connected to a corresponding stopper part; and
the stopper part of each crimp pin is configured to plug-connect to the corresponding accommodation cavity through the corresponding crimp hole, and is configured to prevent the corresponding crimp pin from slipping out of the corresponding crimp hole.

13. The optical cage component according to claim 12, wherein each stopper part has a guide structure.

14. The optical cage component according to claim 12 or 13, wherein the base has a first surface away from a circuit board, a second surface facing the circuit board, and a connection surface connecting the first surface to the second surface;
each crimp hole extends from the accommodation cavity to the first surface; and
each first connection section extends in a direction perpendicular to the mounting surface.

15. The optical cage component according to claim 12 or 13, wherein the base has a first surface away from a circuit board, a second surface facing the circuit board, and a connection surface connecting the first surface to the second surface;
each crimp hole extends from the accommodation cavity to the connection surface; and
a second connection section is further disposed between each first connection section and the corresponding stopper part, and an included angle between an extension direction of the second connection section and the mounting surface is an acute angle.

16. The optical cage component according to claim 11, wherein each crimp pin has one or more hanging holes, and an opening direction of the hanging hole is parallel to the mounting surface; and
a plurality of protrusion parts in a one-to-one correspondence with the one or more hanging holes are disposed on a connection surface of the base, and each protrusion part is configured to plug-connect to a corresponding hanging hole.

17. The optical cage component according to claim 16, wherein a surface that is of each protrusion part and that is away from a circuit board forms a guide surface.

18. An optical communications device, comprising:
a circuit board; and
the optical cage component according to any one of claims 1 to 17, wherein a base is fixed on a surface of the circuit board, and a mounting surface of an optical cage is connected to the base.
